# EUROPEAN PATENT APPLICATION

(11) **EP 4 848 286 A1**
(43) Date of publication of application: **02.12.2026**
(21) Application number: 26156779.6
(22) Date of filing: 06.02.2026
(51) Int. Cl.: G11C 7/10, G11C 7/22

(54) **MEMORY DEVICE**

(30) Priority: 30.05.2025 KR 20250071217
(71) Applicant: SK hynix Inc., Bubal-eub Icheon-si Gyeonggi-do 17336 (KR)
(72) Inventor: MOON, Ji Seong, 17336 Icheon-si, Gyeonggi-do (KR); KIM, Young Il, 17336 Icheon-si, Gyeonggi-do (KR); GOO, Ja Yoon, 17336 Icheon-si, Gyeonggi-do (KR); SEOL, Hyeon Cheon, 17336 Icheon-si, Gyeonggi-do (KR); OK, Sung Hwa, 17336 Icheon-si, Gyeonggi-do (KR); LEE, Su Han, 17336 Icheon-si, Gyeonggi-do (KR)
(74) Representative: Isarpatent

(57) **Abstract**

A memory device includes a memory cell section, an encoder configured to encode data read from the memory cell section and output the encoded data in synchronization with an internal clock signal and deactivated in response to an encoder deactivation signal, and a control circuit configured to identify a first quantity of closure clock cycles of an internal clock signal based on a column address and activate the encoder deactivation signal based on a first closure clock cycle other than a last closure clock cycle among the closure clock cycles.

## Description

### BACKGROUND

### 1. Technical Field

The present application generally relates to a memory device.

### 2. Related Art

Semiconductor devices as core components of electronic devices have a wide range of applications and may be utilized, for example, in technologies such as computing, communication, artificial intelligence, and memory. The semiconductor device may include a transistor, a diode, an integrated circuit (IC), and the like.

The development of semiconductor devices are evolving toward high integration and high speed. Technological developments may increase the quantity of transistors per unit area, improve the operating speed, and reduce power consumption. To meet these improvements, various voltage levels are used in semiconductor devices, and stable operation at a low voltage is a challenge.

### SUMMARY

In an embodiment of the present disclosure, a memory device may include a memory cell section; an encoder; and a control circuit. The encoder may be configured to encode data read from the memory cell section and output encoded data in synchronization with an internal clock signal and deactivated in response to an encoder deactivation signal. The control circuit may be configured to identify a quantity of closure clock cycles in the internal clock signal based on a column address and activate the encoder deactivation signal based on a first closure clock cycle other than a last closure clock cycle among the closure clock cycles.

In an embodiment of the present disclosure, a memory device includes memory cell sections; a voltage generation circuit; a slew rate control circuit; and a control circuit. The voltage generation circuit may be configured to control a slew rate in response to a slew rate control signal. The slew rate control circuit may be configured to activate the slew rate control signal in response to a trigger signal. The control circuit may be configured to, in a compressed data output operation for the memory cell sections, identify a quantity of closure clock cycles in an internal clock signal based on a column address and activate the trigger signal based on a first closure clock cycle other than a last closure clock cycle among the closure clock cycles.

In an embodiment of the present disclosure, a memory device may include memory cell sections; first data processing circuits; second data processing circuits; and a control circuit. The first data processing circuits may be configured to process data read from the memory cell sections in parallel. The second data processing circuits may be configured to process data output from the first data processing circuits in parallel. The control circuit may be configured to deactivate the second data processing circuits preceding deactivation of the first data processing circuits.

### BRIEF DESCRIPTION OF THE DRAWINGS

FIG. 1 is a block diagram illustrating a memory device according to an embodiment of the present disclosure;
FIG. 2 is a block diagram illustrating a first memory section according to an embodiment of the present disclosure;
FIG. 3 is a diagram of a memory device during a compressed data output operation according to an embodiment of the present disclosure;
FIG. 4 is a circuit diagram illustrating an encoder deactivation circuit according to an embodiment of the present disclosure;
FIG. 5 is a timing diagram during a compressed data output operation of a memory device according to an embodiment of the present disclosure;
FIG. 6 is a circuit diagram illustrating a voltage generation circuit according to an embodiment of the present disclosure;
FIG. 7 is a block diagram illustrating control circuits and a voltage generation circuit according to an embodiment of the present disclosure;
FIG. 8A is a circuit diagram illustrating a slew rate control circuit according to an embodiment of the present disclosure, and FIG. 8B is a circuit diagram illustrating a target level control circuit according to an embodiment of the present disclosure;
FIG. 9 is a timing diagram during a compressed data output operation of a memory device according to an embodiment of the present disclosure; and
FIG. 10 is a circuit diagram illustrating a control circuit according to an embodiment of the present disclosure.

### DETAILED DESCRIPTION

Embodiments of the present disclosure are described in detail with reference to the accompanying drawings. Specific structural or functional descriptions of embodiments are provided as examples to describe concepts that are disclosed in the present application. Examples or embodiments in accordance with the concepts may be carried out in various forms, and the scope of the present disclosure is not limited to the examples or embodiments described in this specification.

Terms such as "first" and "second" are used to distinguish between various elements and do not imply size, order, priority, quantity, or importance of the elements. For example, a first element may be referred to as a second element in one example, and the second element may be referred to as a first element in another example.-

As circuit elements become smaller and faster, circuit reliability may deteriorate due to operational abnormality, for example, overshoot, undershoot, and so forth caused by fluctuation of internal voltage. Accordingly, stability of the voltages in the semiconductor device is advantageous.

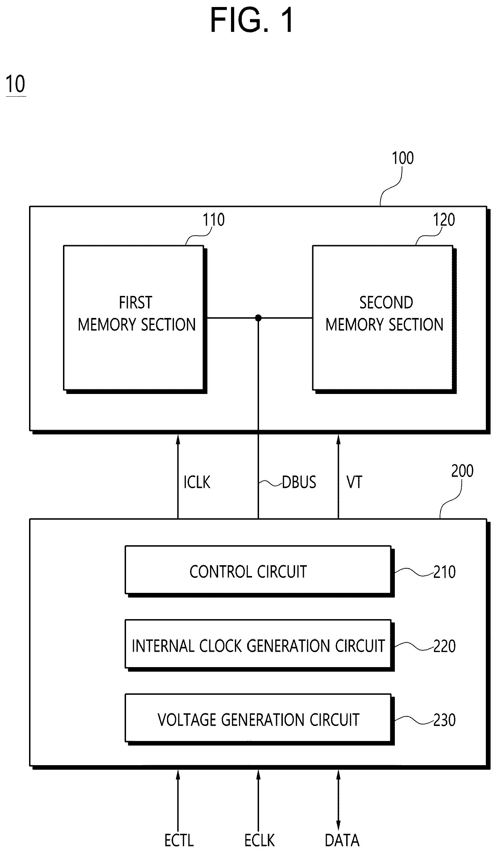

FIG. 1 is a block diagram illustrating a memory device 10 according to an embodiment.

Referring to FIG. 1, the memory device 10 includes data storage unit 100 and a peripheral circuit 200.

The data storage unit 100 includes a first memory section or area 110 and a second memory section or area 120. The memory sections 110 and 120 share a data bus DBUS. Through the data bus DBUS, the memory sections 110 and 120 receive data DATA from the peripheral circuit 200 or output data DATA to the peripheral circuit 200. The memory sections 110 and 120 operate based on an internal clock signal ICLK and an operation voltage VT transmitted from the peripheral circuit 200. The data storage unit 100 may include one or more memory sections in addition to the memory sections 110 and 120 illustrated in FIG. 1.

The peripheral circuit 200 controls overall operation of the memory device 10 in response to an external control signal ECTL received from an external device, for example, a host. In an embodiment, the peripheral circuit 200 stores data DATA received from the external device in the data storage unit 100 in response to the external control signal ECTL that controls program operation. The peripheral circuit 200 outputs data DATA read from the data storage unit 100 to the external device in response to the external control signal ECTL that controls a read operation. The peripheral circuit 200 may output data read from the memory sections 110 and 120 to the external device in parallel in response to the external control signal ECTL that controls a compressed data output operation.

The peripheral circuit 200 includes a control circuit 210, an internal clock generation circuit 220, and a voltage generation circuit 230.

The control circuit 210 controls internal circuits of the memory device 10 including the internal clock generation circuit 220 and the voltage generation circuit 230 based on an operation command and an address included in the external control signal ECTL.

The internal clock generation circuit 220 outputs the internal clock signal ICLK based on the external clock signal ECLK.

Before the external clock signal ECLK is activated during the compressed data output operation, the internal clock generation circuit 220 outputs a quantity, N, of dummy clock cycles, where N is a natural number, as the internal clock signal ICLK regardless of the state of the external clock signal ECLK. The internal clock generation circuit 220 subsequently outputs the external clock signal ECLK at an activated state as the internal clock signal ICLK. Because the internal clock signal ICLK includes the N dummy clock cycles at the beginning of the internal clock signal ICLK, the internal clock signal ICLK includes a quantity, N, of closure clock cycles after the dummy clock signals or at the end of the internal clock signal ICLK.

The voltage generation circuit 230 generates the operation voltage VT used in the data storage unit 100.

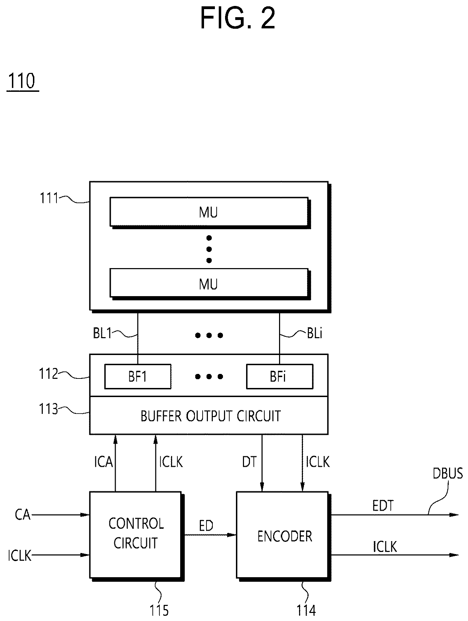

FIG. 2 is a block diagram illustrating the first memory section 110 according to an embodiment.

Referring to FIG. 2, the first memory section 110 includes a memory cell section 111, a buffer circuit 112, a buffer output circuit 113, an encoder 114, and a control circuit 115.

The memory cell section 111 includes a plurality of memory units MU, each of which is a unit by which the program operation or the read operation is performed. Each of the memory units MU includes a plurality of memory cells in which data are stored. Each memory unit MU is coupled to a corresponding word line and is accessed by applying a predetermined voltage to the corresponding word line. The memory cells included in each memory unit MU are coupled to a command word line and coupled to bit lines BL1 to BLi.

The buffer circuit 112 stores data read from the memory cell section 111. The buffer circuit 112 includes sub buffers BF1 to BFi. The sub buffers BF1 to BFi are coupled to the memory units MU through the bit lines BL1 to BLi. The sub buffers BF1 to BFi receive and store data that are read from the memory cells of a selected memory unit MU among the memory units MU through the bit lines BL1 to BLi.

The buffer output circuit 113 receives an internal column address ICA and the internal clock signal ICLK from the control circuit 115. The buffer output circuit 113 selects a sub buffer corresponding to the internal column address ICA from among the sub buffers BF1 to BFi in response to the internal column address ICA and outputs data DT stored in the selected sub buffer to the encoder 114 in synchronization with the internal clock signal ICLK.

The encoder 114 encodes the data DT output from the buffer output circuit 113 according to a predetermined encoding rule and outputs encoded data EDT to the data bus DBUS in synchronization with the internal clock signal ICLK. A quantity of bits of the encoded data EDT output from the encoder 114 per clock cycle of the internal clock signal ICLK is less than a quantity of bits of the data DT input to the encoder 114 per clock cycle of the internal clock signal ICLK. The encoder 114 is deactivated in response to an encoder deactivation signal ED output from the control circuit 115.

The control circuit 115 generates the internal column address ICA based on a column address CA and the internal clock signal ICLK received from the peripheral circuit 200 and transmits the internal column address ICA and the internal clock signal ICLK to the buffer output circuit 113. The column address CA is output to the data storage unit 100 by the control circuit 210 based on an address included in the external control signal ECTL.

The control circuit 115 outputs the encoder deactivation signal ED based on the column address CA and the internal clock signal ICLK in the compressed data output operation. In an embodiment, the control circuit 115 identifies closure clock cycles in the internal clock signal ICLK by counting the clock cycles of the internal clock signal ICLK based on the column address CA and activates the encode deactivation signal ED based on a predetermined n-th closure clock cycle, where n is a natural number less than N, other than a last closure clock cycle among the closure clock cycles. The control circuit 115 activates the encoder deactivation signal ED at a rising edge or a falling edge of the n-th closure clock cycle.

The second memory section 120 is configured and operates similarly to the first memory section 110. An encoder 114 included in the second memory section 120 is similarly coupled to the data bus DBUS.

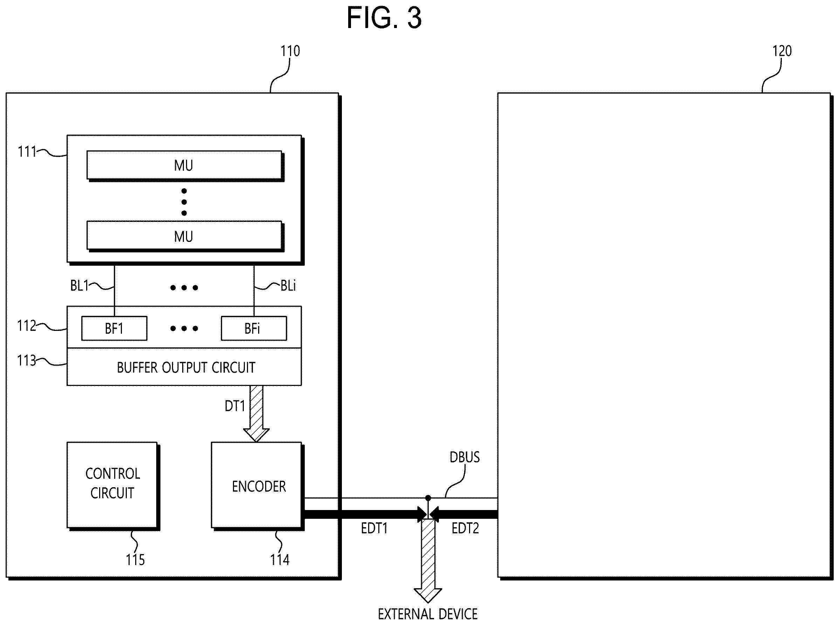

FIG. 3 is a diagram of a memory device during a compressed data output operation according to an embodiment.

Referring to FIG. 3, during the compressed data output operation, encoded data EDT1 output from the first memory section 110 and encoded data EDT2 output from the second memory section 120 is simultaneously output to the external device over the data bus DBUS.

In an embodiment, data DT1 stored in the buffer circuit 112 is transmitted to the encoder 114 through the buffer output circuit 113. During the data transmission process, the data DT1 is transmitted to the encoder 114 utilizing 100% of the width of the data bus DBUS as illustrated by an oblique-lined arrow.

The encoder 114 outputs the encoded data EDT1 to the data bus DBUS. During the data output process, the encoded data EDT1 is transmitted utilizing no more than 50% of the width of the data bus DBUS as illustrated by a shaded arrow. For example, when the width of the data bus DBUS is 8 bits, the encoder 114 receives 8-bit data DT1 and outputs 4-bit encoded data EDT1.

The encoded data EDT2 output from the second memory section 120 is transmitted utilizing no more than 50% of the width of the data bus DBUS as illustrated by a shaded arrow. The encoded data EDT1 output from the first memory section 110 and the encoded data EDT2 output from the second memory section 120 are output in parallel utilizing 100% of the width of the data bus DBUS as illustrated by an oblique-lined arrow.

In an embodiment, the memory cell section 111, the buffer circuit 112, the buffer output circuit 113, and the encoder 114 are included in a first set, and the first memory section 110 may include a second set including a second memory cell section, a second buffer circuit, a second buffer output circuit, and a second encoder. The components of the second set are configured and operate similarly to the components of the first set. The second encoder is coupled to the data bus DBUS. During the compressed data output operation, the first set and the second set operate in parallel according to control of the control circuit 115. The encoder deactivation signal ED output from the control circuit 115 is individually input to the encoder 114 and the second encoder. The second memory section 120 may be configured similarly to the first memory section 110. In an embodiment, the data storage unit 100 includes four encoders sharing the data bus DBUS. During the compressed data output operation, each of the four encoders outputs the encoded data to the data bus DBUS utilizing no more than 25% of the width of the data bus DBUS.

As described, because the memory sections 110 and 120 operate simultaneously, the compressed data output operation consumes a large amount of current. When the internal circuits of the memory sections 110 and 120 simultaneously terminate operations, for example, are simultaneously deactivated, the amount of power consumption suddenly reduces significantly, and overshoot occurs in an output node where the operation voltage VT is output from the voltage generation circuit 230. Such overshoot may cause circuit damage, unexpected malfunction, waste of power, and so forth, and operation performance of the memory device 10 may deteriorate.

The internal clock signal ICLK output from the internal clock generation circuit 220 is transmitted in the order of the control circuit 115, the buffer output circuit 113, and the encoder 114. The buffer output circuit 113 is deactivated in response to the deactivated internal clock signal ICLK. In an embodiment, the encoder 114 is deactivated at a time earlier than a deactivation time of the buffer output circuit 113 in response to the encoder deactivation signal ED before the internal clock signal ICLK is deactivated. Such a deactivation time control method is similarly performed in the second memory section 120. As a result, according to an embodiment, because the deactivation times of the buffer output circuit 113 and the encoder 114 are distributed, overshoot in the output node where the operation voltage VT is output from the voltage generation circuit 230 may be suppressed.

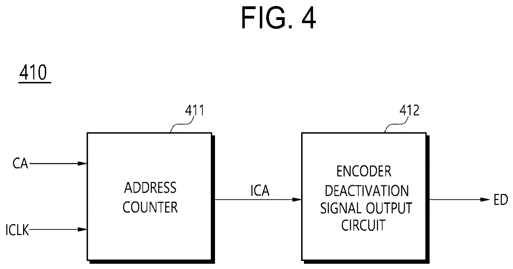

FIG. 4 is a circuit diagram illustrating an encoder deactivation circuit 410 according to an embodiment.

Referring to FIG. 4, the encoder deactivation circuit 410 may be included in the control circuit 115. The encoder deactivation circuit 410 counts rising or falling edges of the internal clock signal ICLK based on the column address CA and activates the encoder deactivation signal ED in the n-th closure clock cycle. The encoder deactivation circuit 410 deactivates the encoder deactivation signal ED in response to the deactivated internal clock signal ICLK.

The encoder deactivation circuit 410 includes an address counter 411 and an encoder deactivation signal output circuit 412.

The address counter 411 counts the internal clock signal ICLK based on the column address CA to output the internal column address ICA. The address counter 411 sequentially increases a value of the column address CA in response to the internal clock signal ICLK and outputs the increased column address as the internal column address ICA. The column address CA designates a sub buffer in which the data output starts in the buffer circuit 112. As described with reference to FIG. 2, the internal column address ICA is output to the buffer output circuit 113.

The encoder deactivation signal output circuit 412 activates the encoder deactivation signal ED based on the internal column address ICA. In an embodiment, when the compressed data output operation is performed up to a predetermined position in the buffer circuit 112, for example, the last sub buffer BFi in the buffer circuit 112, the internal column address ICA, that is output after the internal column address ICA indicates the last sub buffer BFi, is output based on the closure clock cycles of the internal clock signal ICLK. Accordingly, the encoder deactivation signal output circuit 412 determines that a predetermined value of the internal column address ICA, for example, a value subsequent to the value corresponding to the last sub buffer BFi, corresponds to a first closure clock cycle in the internal clock signal ICLK. The encoder deactivation signal output circuit 412 activates the encoder deactivation signal ED in response to receiving the n-th value of a predetermined value of the internal column address ICA.

The encoder deactivation signal output circuit 412 deactivates the encoder deactivation signal ED based on a determination that the internal column address ICA is not further increased. In an embodiment, the encoder deactivation signal output circuit 412 deactivates the encoder deactivation signal ED based on the internal column address ICA reaching a predetermined value.

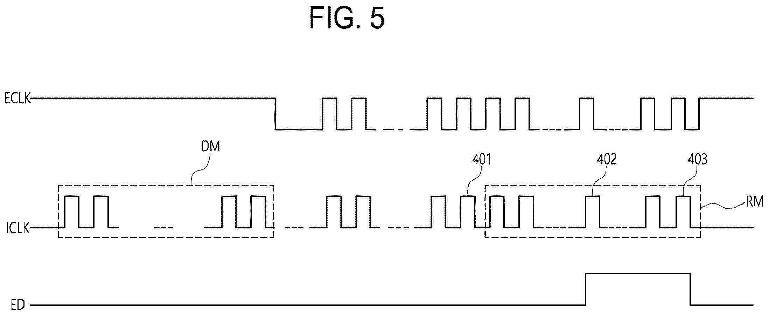

FIG. 5 is a timing diagram during a compressed data output operation of the memory device 10 according to an embodiment.

Referring to FIG. 5, the external clock signal ECLK is in a deactivated state, for example, at a logic high level at the beginning of the timing diagram. Before the external clock signal ECLK is activated, referred to as toggled, a quantity, N, of dummy clock cycles DM is output as the internal clock signal ICLK. A total execution time of the compressed data output operation is shortened because the dummy clock cycles DM by enable the memory device 10 to initiate the compressed data output operation earlier without waiting for the external clock signal ECLK to begin toggling.

The internal clock signal ICLK is output based on the external clock signal ECLK of an activated state. In an embodiment, the internal clock signal ICLK includes N closure clock cycles RM at the end of the internal clock signal ICLK sequence. Because the compressed data output operation is initiated early based on the N dummy clock cycles DM before the external clock signal ECLK is activated, the compressed data output operation is terminated during a clock cycle 401 immediately before the closure clock cycles RM begin. Thus, the closure clock cycles RM may be ignored, disregarded, or unprocessed.

The encoder deactivation signal ED is activated based on the n-th closure clock cycle 402 among the closure clock cycles RM. In an embodiment, the value n is less than the value N. For example, the n-th closure clock cycle 402 precedes a last closure clock cycle 403.

Because the encoder 114 is deactivated based on the n-th closure clock cycle 402 and the buffer output circuit 113 is deactivated based on the last closure clock cycle 403, the deactivation time of the buffer output circuit 113 is later than the deactivation time of the encoder 114, which deactivation times are distributed, separated, or offset in time. Accordingly, overshoot may be suppressed at the output node where the operation voltage VT is output from the voltage generation circuit 230.

In an embodiment, the method of distributing the deactivation times of the encoders and the buffer output circuits may be similarly applied to data processing circuits in each memory section. For example, the memory device 10 includes first data processing circuits configured to process data read from the memory cell sections in parallel, second data processing circuits configured to process data output from the first data processing circuits in parallel, and a control circuit configured to deactivate the second data processing circuits before the first data processing circuits. In an embodiment, the first data processing circuits are the buffer output circuits and the second data processing circuits may be the encoders. In an embodiment, the first data processing circuits are the encoders and the second data processing circuits are the buffer output circuits.

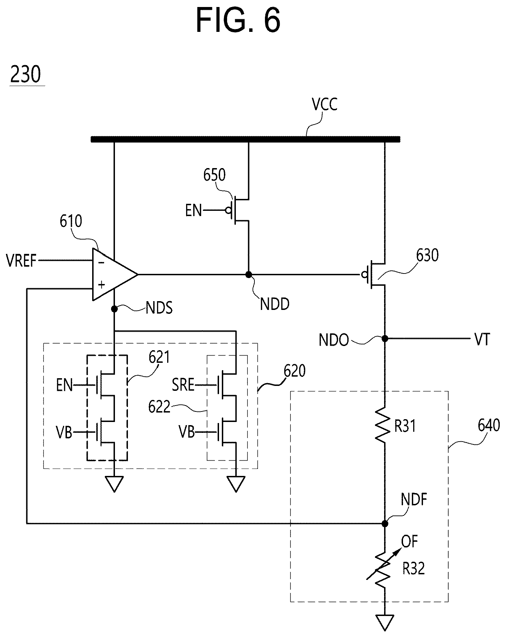

FIG. 6 is a circuit diagram illustrating the voltage generation circuit 230 according to an embodiment.

Referring to FIG. 6, the voltage generation circuit 230 includes a comparison circuit 610, a slew rate control circuit 620, a driving circuit 630, a voltage divider circuit 640, and an activation circuit 650.

A reference voltage VREF is received at an inverting terminal (-), and a voltage at a feedback node NDF is received at a noninverting terminal (+) of the comparison circuit 610. The comparison circuit 610 compares the reference voltage VREF and the voltage of the feedback node NDF and outputs a voltage according to a comparison result to a driving node NDD. For example, the comparison circuit 610 reduces a voltage at the driving node NDD when the voltage of the feedback node NDF is lower than the reference voltage VREF. The comparison circuit 610 increases the voltage at the driving node NDD when the voltage of the feedback node NDF is higher than the reference voltage VREF. The comparison circuit 610 may include an operational amplifier.

The slew rate control circuit 620 is coupled to the comparison circuit 610 through a sink node NDS and couples the comparison circuit 610 to a ground node in response to an activation signal EN and a slew rate control signal SRE. The slew rate control circuit 620 controls or adjusts a slew rate of the voltage generation circuit 230 in response to the slew rate control signal SRE. More specifically, the slew rate control circuit 620 increases a slew rate of the voltage generation circuit 230 by increasing an amount of current flowing in the comparison circuit 610 in response to the slew rate control signal SRE. When the slew rate control signal SRE is activated, the response speed of the voltage generation circuit 230 may be improved, and the voltage generation circuit 230 may more stably output the operation voltage VT.

The slew rate control circuit 620 includes a first regulation circuit 621 and a second regulation circuit 622. The first regulation circuit 621 includes NMOS transistors coupled in series between the sink node NDS and the ground node and receives the activation signal EN and a bias voltage VB at gates of the NMOS transistors. The second regulation circuit 622 includes NMOS transistors coupled in series between the sink node NDS and the ground node and receives the slew rate control signal SRE and the bias voltage VB at gates of the NMOS transistors.

The driving circuit 630 is coupled between a power node VCC and an output node NDO that outputs the operation voltage VT. The driving circuit 630 drives the output node NDO at a voltage of the power node VCC in response to a voltage of the driving node NDD. For example, the driving circuit 630 may include a PMOS transistor. The PMOS transistor drives the output node NDO at the voltage of the power node VCC in response to the voltage of the driving node NDD received through a gate of the driving circuit 630.

The voltage divider circuit 640 includes resistors R31 and R32 coupled in series between the output node NDO and the ground node. The voltage divider circuit 640 divides the voltage at the output node NDO and provides a divided voltage to the feedback node NDF between the resistors R31 and R32. The resistor R32 is a variable resistor at a resistance value varied according to a target level control signal OF. For example, the resistance value of the resistor R32 may be reduced in response to the target level control signal OF. Accordingly, when the target level control signal OF is activated, a target level of the operation voltage VT output to the output node NDO is increased.

In an embodiment, to increase the target level of the output node NDO using the target level control signal OF compensates for voltage drop occurring in the output node NDO due to a termination time of a predetermined internal operation. During the compressed data output operation, when the target level of the output node NDO is increased, overshoot occurring in the output node NDO may be worsened.

The activation circuit 650 is coupled between the power node VCC and the driving node NDD. The activation circuit 650 drives the driving node NDD at the voltage of the power node VCC based on the deactivated activation signal EN. Accordingly, the driving circuit 630 coupled to the driving node NDD is deactivated and the operation voltage VT is not generated. The activation circuit 650 separates the power node VCC and the driving node NDD based on the activated activation signal EN. Accordingly, the driving circuit 630 coupled to the driving node NDD drives the output node NDO at the voltage of the power node VCC based on the voltage of the driving node NDD. For example, the activation circuit 650 may include a PMOS transistor. The PMOS transistor separates the power node VCC and the driving node NDD based on the activated activation signal EN received through a gate of the PMOS transistor.

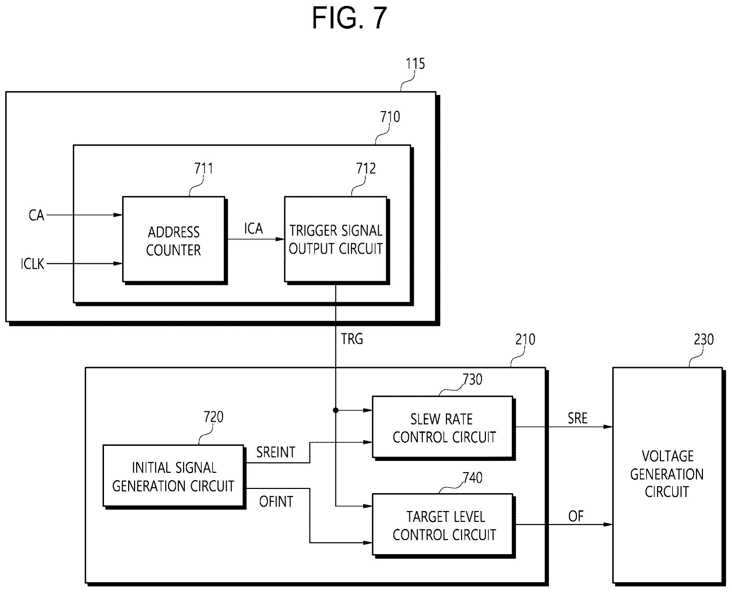

FIG. 7 is a block diagram illustrating the control circuit 115, the control circuit 210, and the voltage generation circuit 230 according to an embodiment.

Referring to FIG. 7, the control circuit 115 includes a trigger circuit 710. The trigger circuit 710 identifies the closure clock cycles RM by counting rising or falling edges of the internal clock signal ICLK based on the column address CA and activates a trigger signal TRG in an m-th closure clock cycle, where m is a natural number less than N. The trigger circuit 710 activates the trigger signal TRG either a rising edge or a falling edge of the m-th closure clock cycle.

In an embodiment, the trigger circuit 710 is configured similarly to the encoder deactivation circuit 410 of FIG. 4 except that the trigger circuit 710 activates the trigger signal TRG in the m-th closure clock cycle rather than the n-th closure clock cycle. The trigger circuit 710 includes an address counter 711 and a trigger signal output circuit 712. The address counter 711 is configured and operates similarly to the address counter 411 of FIG. 4. The trigger signal output circuit 712 activates the trigger signal TRG in response to receiving the m-th value of a predetermined value of the internal column address ICA.

The control circuit 210 outputs the slew rate control signal SRE and the target level control signal OF to the voltage generation circuit 230 based on the trigger signal TRG. In an embodiment, the control circuit 210 activates the slew rate control signal SRE while the trigger signal TRG is activated. The control circuit 210 outputs the target level control signal OF at a deactivated state while the trigger signal TRG is activated.

The control circuit 210 includes an initial signal generation circuit 720, a slew rate control circuit 730, and a target level control circuit 740.

The initial signal generation circuit 720 outputs an initial slew rate control signal SREINT and an initial target level control signal OFINT. For example, the initial slew rate control signal SREINT is activated for a predetermined time period including the termination time of the predetermined internal operation of the memory device 10. The initial target level control signal OFINT is activated for a predetermined time period including the termination time of the predetermined internal operation of the memory device 10. The predetermined internal operation includes the compressed data output operation.

The slew rate control circuit 730 outputs the slew rate control signal SRE based on the initial slew rate control signal SREINT and the trigger signal TRG. In an embodiment, the slew rate control circuit 730 activates the slew rate control signal SRE while the initial slew rate control signal SREINT or the trigger signal TRG is activated.

The target level control circuit 740 outputs the target level control signal OF based on the initial target level control signal OFINT and the trigger signal TRG. In an embodiment, when the trigger signal TRG is in a deactivated state, the target level control circuit 740 outputs the target level control signal OF based on the initial target level control signal OFINT. When the trigger signal TRG is in an activated state, the target level control circuit 740 maintains the target level control signal OF in the deactivated state. For example, when the trigger signal TRG is in the activated state, the target level control circuit 740 masks the initial target level control signal OFINT.

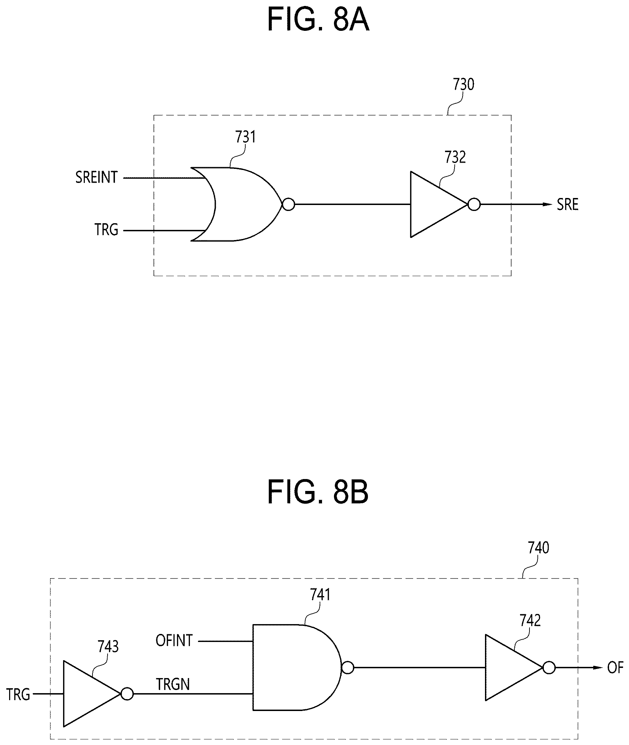

FIG. 8A is a circuit diagram illustrating the slew rate control circuit 730 according to an embodiment, and FIG. 8B is a circuit diagram illustrating the target level control circuit 740 according to an embodiment.

Referring to FIG. 8A, the slew rate control circuit 730 includes a NOR gate 731 and an inverter 732. The NOR gate 731 performs a NOR operation on the initial slew rate control signal SREINT and the trigger signal TRG and outputs an NOR operation result to the inverter 732. The inverter 732 inverts the NOR operation result and outputs the slew rate control signal SRE.

Referring to FIG. 8B, the target level control circuit 740 includes a NAND gate 741 and inverters 742 and 743. The inverter 743 inverts the trigger signal TRG to output an inverted trigger signal TRGN. The NAND gate 741 performs a NAND operation on the initial target level control signal OFINT and the inverted trigger signal TRGN and outputs a NAND operation result. The inverter 742 inverts the NAND operation result and outputs the target level control signal OF.

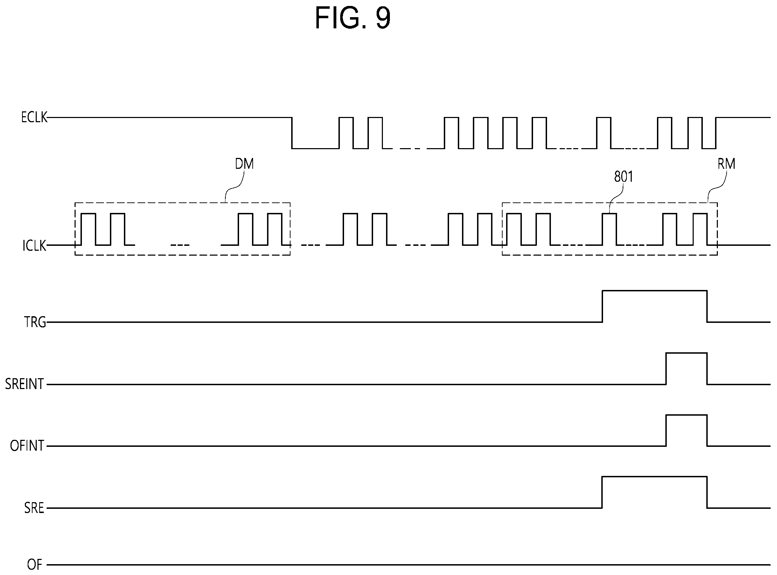

FIG. 9 is a timing diagram during a compressed data output operation of a memory device 10 according to an embodiment.

Referring to FIG. 9, the internal clock signal ICLK is generated by the process described with reference to FIG. 5.

The initial slew rate control signal SREINT and the initial target level control signal OFINT are generated before the termination time of the compressed data output operation. In an embodiment, the initial slew rate control signal SREINT is activated at the same time as the initial target level control signal OFINT is activated.

The trigger signal TRG is activated based on an m-th closure clock cycle 801.

The slew rate control signal SRE is activated while the trigger signal TRG is activated. As a slew rate of the voltage generation circuit 230 is increased in response to the slew rate control signal SRE, the voltage generation circuit 230 may more stably output the operation voltage VT and overshoot in the output node NDO of the voltage generation circuit 230 may be suppressed.

Even when the initial target level control signal OFINT is activated while the trigger signal TRG is activated, the target level control signal OF is maintained in the deactivated state. Accordingly, the target level of the output node NDO of the voltage generation circuit 230 is not changed near the termination time of the compressed data output operation and overshoot occurring in the output node NDO may not be worsened.

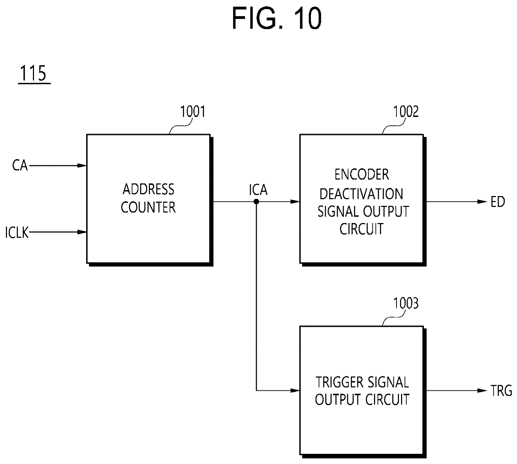

FIG. 10 is a circuit diagram illustrating the control circuit 115 according to an embodiment.

Referring to FIG. 10, the control circuit 115 includes an address counter 1001, an encoder deactivation signal output circuit 1002, and a trigger signal output circuit 1003. The address counter 1001 and the encoder deactivation signal output circuit 1002 are configured and operate similarly to the address counter 411 and the encoder deactivation signal output circuit 412 of FIG. 4, respectively. The trigger signal output circuit 1003 is configured and operates similarly to the trigger signal output circuit 712 of FIG. 7.

In an embodiment, the control circuit 115 activates the trigger signal TRG based on the m-th closure clock cycle 801 and activates the encoder deactivation signal ED based on the n-th closure clock cycle 402. In an embodiment, the m-th closure clock cycle 801 precedes the n-th closure clock cycle 402. For example, the trigger signal TRG is activated before the encoder deactivation signal ED. As described, the encoder deactivation signal ED and the trigger signal TRG are input to the encoder 114 and the control circuit 210, respectively.

According to embodiments of the present disclosure, a memory device can suppress voltage overshoot.

Concepts are disclosed in conjunction with examples and embodiments. Those skilled in the art will understand that various modifications, additions, combinations, and substitutions are possible without departing from the scope and technical concepts of the present disclosure. The embodiments disclosed in the present specification should be considered from an illustrative standpoint and not a restrictive standpoint. Therefore, the scope of the present disclosure is not limited to these descriptions. All changes within the meaning and range of equivalency of the claims are included within their scope.

## Claims

1. A memory device comprising:
a first memory cell section;
a first encoder configured to encode first data read from the first memory cell section and output encoded first data in synchronization with an internal clock signal and deactivated in response to an encoder deactivation signal; and
a control circuit configured to identify a quantity of closure clock cycles in the internal clock signal based on a column address and activate the encoder deactivation signal based on -a first closure clock cycle other than a last closure clock cycle among the closure clock cycles.

2. The memory device of claim 1, wherein the control circuit counts rising or falling edges of the internal clock signal based on the column address to output an internal column address, the memory device further comprising:
a buffer circuit configured to store the first data read from the first memory cell section; and
a buffer output circuit configured to, in response to receiving the internal column address, output the first data stored in the buffer circuit to the first encoder in synchronization with the internal clock signal.

3. The memory device of claim 2, wherein the internal clock signal is transmitted from the control circuit to the first encoder via the buffer output circuit.

4. The memory device of claim 1, wherein a quantity of bits of the encoded first data output from the first encoder per clock cycle of the internal clock signal is less than a quantity of bits of the first data read from the first memory cell section and input to the first encoder per clock cycle.

5. The memory device of claim 1, further comprising a clock generation circuit configured to generate the internal clock signal based on an external clock signal received from an external device;
wherein the clock generation circuit outputs a quantity of dummy clock cycles as the internal clock signal before the external clock signal is activated.

6. The memory device of claim 1, further comprising:
a second memory cell section; and
a second encoder configured to encode second data read from the second memory cell section and output encoded second data in synchronization with the internal clock signal and deactivated in response to the encoder deactivation signal;
wherein the first encoder and the second encoder output the encoded first data in parallel with the encoded second data to a data bus.

7. The memory device of claim 1, further comprising:
a slew rate control circuit configured to activate a slew rate control signal while a trigger signal is activated; and
a voltage generation circuit configured to control a slew rate in response to the slew rate control signal;
wherein the control circuit activates the trigger signal based on a second closure clock cycle preceding the first closure clock cycle among the closure clock cycles.

8. The memory device of claim 7, further comprising:
an initial signal generation circuit configured to activate an initial slew rate control signal for a predetermining time including a termination time of a predetermined internal operation;
wherein the slew rate control circuit activates the slew rate control signal while the trigger signal or the initial slew rate control signal is activated.

9. The memory device of claim 1, further comprising:
a target level control circuit configured to output an initial target level control signal as a target level control signal while a trigger signal is deactivated and output the target level control signal of a deactivated state while the trigger signal is activated; and
a voltage generation circuit configured to generate an operation voltage supplied to the first encoder and control a target level of the operation voltage in response to the target level control signal;
wherein the control circuit activates the trigger signal based on a second closure clock cycle preceding the first closure clock cycle among the closure clock cycles.

10. The memory device of claim 9, further comprising an initial signal generation circuit configured to activate the initial target level control signal for a predetermined time including a termination time of a predetermined internal operation.

11. A memory device comprising:
memory cell sections;
a voltage generation circuit configured to control a slew rate in response to a slew rate control signal;
a slew rate control circuit configured to activate the slew rate control signal in response to a trigger signal; and
a control circuit configured to, in a compressed data output operation for the memory cell sections, identify a quantity of closure clock cycles in an internal clock signal based on a column address and activate the trigger signal based on a first closure clock cycle other than a last closure clock cycle among the closure clock cycles.

12. The memory device of claim 11, further comprising an initial signal generation circuit configured to activate an initial slew rate control signal for a predetermined time including a termination time of a predetermined internal operation;
wherein the slew rate control circuit activates the slew rate control signal while the trigger signal or the initial slew rate control signal is activated.

13. The memory device of claim 11, further comprising a target level control circuit configured to output an initial target level control signal as a target level control signal while the trigger signal is deactivated and output the target level control signal of a deactivated state while the trigger signal is activated;
wherein the voltage generation circuit controls a target level of an output voltage supplied to the encoder in response to the target level control signal.

14. The memory device of claim 11, further comprising:
buffer circuits configured to store, during the compressed data output operation, data read in parallel from the memory cell sections; and
buffer output circuits individually coupled to the buffer circuits;
wherein each of the buffer output circuits outputs data stored in a corresponding buffer circuit in synchronization with the internal clock signal.

15. A memory device comprising:
memory cell sections;
first data processing circuits configured to process data read from the memory cell sections in parallel;
second data processing circuits configured to process data output from the first data processing circuits in parallel; and
a control circuit configured to deactivate the second data processing circuits preceding deactivation of the first data processing circuits.
